# EUROPÄISCHE PATENTSCHRIFT

(11) **EP 2 642 663 B1**
(45) Veröffentlichungstag und Bekanntmachung des Hinweises auf die Patenterteilung: **15.06.2016**
(21) Anmeldenummer: 12001938.5
(22) Anmeldetag: 20.03.2012
(51) Int. Cl.: H03K 17/955, H03K 17/96

(54) **Sensor und Verfahren zum Nachweisen eines Objekts**
Sensor and method for detecting an object
Capteur et procédé destinés à la vérification d'un objet

(43) Veröffentlichungstag der Anmeldung: 25.09.2013
(73) Patentinhaber: Pepperl + Fuchs GmbH, 68307 Mannheim (DE)
(72) Erfinder: Völkel, Hardi, 68519 Viernheim (DE); Vater, Jochen, 68307 Mannheim (DE)
(74) Vertreter: Schiffer, Axel Martin

(56) Entgegenhaltungen:
- WO-A2-2009/150618
- DE-A1-102005 041 113
- DE-B3-102009 045 967
- GB-A- 2 307 609

## Beschreibung

Die vorliegende Erfindung bezieht sich in einem ersten Aspekt auf einen Sensor zum Nachweisen eines Objekts nach dem Oberbegriff des Anspruchs 1.

In einem zweiten Gesichtspunkt betrifft die Erfindung ein Verfahren zum Nachweisen eines Objekts nach dem Oberbegriff des Anspruchs 9.

Ein gattungsgemäßer Sensor umfasst eine Sondenelektrode zum Bilden einer Messkapazität mit dem nachzuweisenden Objekt, einen Ladegenerator zum Erzeugen einer alternierenden Ladespannung, wobei die Sondenelektrode mittels der alternierenden Ladespannung geladen wird, einen Verstärker zum Verstärken einer Spannung über der Messkapazität, wobei der Verstärker einen ersten Versorgungsanschluss und einen zweiten Versorgungsanschluss aufweist, Elektronikmittel zum Verarbeiten von Signalen, die an einem Ausgang des Verstärkers ausgegeben werden, zu mindestens einem Ausgangssignal und mindestens einen Sensorausgang zum Ausgeben des mindestens einen Ausgangssignals.

Bei einem gattungsgemäßen Verfahren zum Nachweisen eines Objekts wird eine Messkapazität mittels einer Sondenelektrode und des nachzuweisenden Objekts gebildet, die Sondenelektrode wird mittels einer alternierenden Ladespannung geladen, mit einem Verstärker wird eine Spannung über der Messkapazität verstärkt, Signale, die an einem Ausgang des Verstärkers ausgegeben werden, werden zu mindestens einem Ausgangssignal verarbeitet und das mindestens eine Ausgangssignal wird ausgegeben.

Aus EP 1 214 787 B1 sind ein solches Verfahren und ein gattungsgemäßer Sensor bekannt. Hierbei wird an beide Versorgungsanschlüsse des Verstärkers eine Wechselspannungsquelle angeschlossen. Die Versorgungsspannung des Verstärkers bleibt dadurch konstant. Indem sowohl die Messelektrode als auch die Versorgungsanschlüsse des Verstärkers an die Wechselspannungsquelle angeschlossen sind, können Kapazitätsänderungen zwischen der Sondenelektrode und dem Messobjekt nachgewiesen werden.

In DE 10 2005 041 113 A1 ist ein gattungsgemäßer Sensor beschrieben. Um einen verbesserten kostengünstigen kapazitiven Näherungsschalter zur Verfügung zu stellen, hat bei diesem Sensor ein Signalausgang des Halbleiterschalters ein dem Taktsignal folgendes Ausgangssignal mit Signalanteilen, die proportional zur Kapazität des mit der Sensorfläche gebildeten Kondensators sind.

Als eine **Aufgabe** der Erfindung kann angesehen werden, einen Sensor zum Nachweisen eines Objekts bereitzustellen, welcher bei kostengünstigem Aufbau besonders genau und resistent gegenüber Störeinflüssen arbeitet. Außerdem soll ein Verfahren zum Nachweisen eines Objekts angegeben werden, welches mit geringem Kostenaufwand möglichst genaue Messungen ermöglicht, die weitgehend resistent gegenüber Störeinflüssen sind.

Diese Aufgabe wird durch den Sensor mit den Merkmalen des Anspruchs 1 und durch das Verfahren mit den Merkmalen des Anspruchs 9 gelöst.

Vorteilhafte Varianten des erfindungsgemäßen Verfahrens und bevorzugte Ausgestaltungen des erfindungsgemäßen Sensors sind Gegenstand der abhängigen Ansprüche und werden außerdem in der folgenden Beschreibung, insbesondere im Zusammenhang mit den Figuren, beschrieben.

Bei dem Sensor der oben genannten Art ist erfindungsgemäß vorgesehen, dass an dem zweiten Versorgungsanschluss als eine zweite Versorgungsspannung eine Gleichspannung angelegt ist und dass an dem ersten Versorgungsanschluss eine erste Versorgungsspannung mit einem Wechselspannungsanteil angelegt ist, wobei zum Erzeugen des Wechselspannungsanteils ein Versorgungsspannungsgenerator vorhanden ist.

Bei dem Verfahren der oben genannten Art ist erfindungsgemäß vorgesehen, dass an einem zweiten Versorgungsanschluss des Verstärkers als eine zweite Versorgungsspannung eine Gleichspannung angeschlossen wird und dass an einem ersten Versorgungsanschluss des Verstärkers eine erste Versorgungsspannung mit einem Wechselspannungsanteil angeschlossen wird, wobei der Wechselspannungsanteil mit einem Versorgungsspannungsgenerator erzeugt wird.

Das erfindungsgemäße Verfahren wird mit dem erfindungsgemäßen Sensor durchgeführt.

Das Messprinzip des erfindungsgemäßen Sensors basiert darauf, dass die Spannung über der Messkapazität durch die alternierende Ladespannung nicht sofort auf einen konstanten Wert springt, sondern ein Lade- und ein Entladevorgang erfolgt, deren Zeitkonstanten von der Höhe der Messkapazität abhängen. Je größer die Messkapazität ist, desto länger dauern der Lade- und der Entladevorgang. Aus der Spannung über der Messkapazität oder aus einem zeitlichen Mittelwert dieser Spannung kann daher auf die Größe der Messkapazität geschlossen werden. Die Größe der Messkapazität hängt wiederum von dem Abstand des nachzuweisenden Objekts ab. Somit ermöglicht die Messung der Spannung über der Messkapazität den Nachweis eines Objekts.

Der Erfindung liegt die Erkenntnis zu Grunde, dass die Messgenauigkeit erhöht werden kann, wenn möglichst keine parasitären Kapazitäten, die den Ladevorgang der Messkapazität beeinflussen, wirken.

Als eine wesentliche Idee der Erfindung kann angesehen werden, eine parasitäre Kapazität, die zwischen dem ersten Versorgungsanschluss und dem Eingang des Verstärkers vorkommt, unwirksam zu machen. Dies erfolgt erfindungsgemäß dadurch, dass an dem ersten Versorgungsanschluss eine Versorgungsspannung mit Wechselspannungsanteil angelegt wird. Eine parasitäre Kapazität verlangsamt den Lade- und Entladevorgang an der Messkapazität und verändert dadurch die zeitlichen Mittelwerte der Spannung über der Messkapazität. Durch den Wechselspannungsanteil wird über der parasitären Kapazität, die mit der Messkapazität einen Spannungsteiler bildet, ein Spannungssprung am Verstärkereingang und damit an der Messkapazität erzeugt. Durch den Spannungssprung wird der zeitliche Mittelwert der Spannung über der Messkapazität gerade so verändert, dass der Einfluss der parasitären Kapazität kompensiert ist. Ein zeitlicher Mittelwert der Spannung über der Messkapazität hängt somit vorteilhafterweise nicht von der Höhe der parasitären Kapazität ab.

Eine weitere grundlegende Idee der Erfindung kann darin gesehen werden, dass der Wechselspannungsanteil nur an dem ersten Versorgungsanschluss anzulegen ist. An dem zweiten Versorgungsanschluss wird hingegen nur eine Gleichspannung angeschlossen. Insbesondere bei Transistorverstärkern wirkt keine parasitäre Kapazität zwischen dem zweiten Versorgungsanschluss und der Verstärkereingang, so dass an diesem Anschluss auch kein Wechselspannungsanteil zum Kompensieren einer parasitären Kapazität erforderlich ist. Die Verwendung einer Gleichspannung am zweiten Versorgungsanschluss erlaubt einen besonders kostengünstigen Aufbau, mit dem dennoch sehr genaue Messungen möglich sind, die nicht oder nur kaum durch parasitäre Kapazitäten beeinflusst werden. Im Unterschied zu bekannten Sensoren ist erfindungsgemäß also die Versorgungsspannung des Verstärkers, die durch die Differenz der Spannungen an den beiden Versorgungsanschlüssen des Verstärkers gegeben ist, nicht konstant sondern wird periodisch variiert, beispielsweise mit einer Rechteckspannung.

In praktischen Realisierungen können geringe Schwankungen einer Gleichspannung nur mit verhältnismäßig großem Aufwand vermieden werden. Daher soll unter der Gleichspannung oder dem Gleichspannungspotenzial, das am zweiten Versorgungsanschluss anzulegen ist, jedes Potenzial verstanden werden können, dessen Höhe während des Betriebs um nicht mehr als 10%, bevorzugt nicht mehr als 5%, insbesondere bezogen auf die minimale Versorgungsspannung des Verstärkers, variiert.

Zum Erzeugen der Gleichspannung, die als zweite Versorgungsspannung an den Verstärker angeschlossen wird, kann eine Spannungsversorgungseinrichtung vorhanden sein. Diese kann von dem Versorgungsspannungsgenerator, mit dem der Wechselspannungsanteil erzeugt wird, verschieden oder von diesem unabhängig sein. Prinzipiell ist auch möglich, dass zum Liefern der zweiten Versorgungsspannung und des Wechselspannungsanteils ein und dieselbe Spannungsversorgungseinrichtung dient.

Bei dem Messobjekt kann es sich um einen Gegenstand aus einem prinzipiell beliebigen Material handeln. Beispielsweise kann das Messobjekt ein Papierbogen sein, eine Holzpalette, ein metallischer Gegenstand, eine Flüssigkeit oder ein Schüttgut, zum Beispiel in einem Toner-Behälter eines Druckers. Für das erfindungsgemäße Verfahren ist es bevorzugt, dass das Objekt Erdbezug hat, das elektrische Potenzial des Objekts also insbesondere gleich dem Massepotenzial ist.

Um die parasitäre Kapazität zwischen dem ersten Versorgungsanschluss und dem Verstärkereingang unschädlich zu machen, sollte der Wechselspannungsanteil der ersten Versorgungsspannung in Frequenz und Phase mit der alternierenden Ladespannung, mit der die Sondenelektrode geladen wird, möglichst übereinstimmen. Hierzu ist bei einer bevorzugten Variante des erfindungsgemäßen Sensors vorgesehen, dass der Ladegenerator und der Versorgungsspannungsgenerator durch ein und denselben Generator gebildet sind und dass der Wechselspannungsanteil der ersten Versorgungsspannung durch die alternierende Ladespannung bestimmt ist. Zudem ist durch Verwendung eines einzigen Generators der Sensoraufbau besonders kostengünstig möglich.

Bei einer vorteilhaften Ausführungsform des erfindungsgemäßen Sensors weicht die Amplitude des Wechselspannungsanteils der Ladespannung maximal um 20% von der Amplitude des Wechselspannungsanteils der ersten Versorgungsspannung ab. Bei Einsatz eines einzigen Generators kann diese Spannungsabweichung beispielsweise durch zusätzliche Dioden oder Widerstände bedingt sein.

Es ist bevorzugt, dass die Versorgungsspannung am ersten Versorgungsanschluss auch einen Gleichspannungsanteil hat. Dieser ist soweit von Erdpotenzial verschieden, dass die Spannung zwischen den beiden Versorgungsanschlüssen zu jeder Zeit hoch genug ist, um den Verstärker in seinem Arbeitsbereich zu betreiben.

Beispielsweise kann der Gleichspannungsanteil eine Höhe zwischen 2V und 20V haben. Insbesondere kann der Gleichspannungsanteil so gewählt werden, dass die erste Versorgungsspannung des Verstärkers zwischen 5V und 10V wechselt.

Eine besonders gute Messgenauigkeit kann erreicht werden, wenn die Amplitude des Wechselspannungsanteils möglichst groß ist.

Zweckmäßigerweise kann die zweite Versorgungsspannung, die an dem zweiten Versorgungsanschluss anliegt, gleich dem Erdpotenzial gewählt sein.

Bei einer bevorzugten Ausführung des erfindungsgemäßen Sensors ist zum Vermeiden einer parasitären Kapazität zwischen dem zweiten Versorgungsanschluss und dem Verstärkereingang der Verstärker ein Transistorverstärker in Kollektorschaltung, insbesondere eine Darlingtonschaltung in Kollektorschaltung oder eine komplementäre Darlingtonschaltung in Kollektorschaltung. Je nach Aufbau des Verstärkers kann der zweite Versorgungsanschluss, an dem die Gleichspannung anliegt, entweder der positive oder der negative Versorgungsanschluss sein. Bei Verwendung eines npn-Transistorverstärkers ist die zweite Versorgungsspannung eine konstante negative Versorgungsspannung, während die erste Versorgungsspannung eine positive Versorgungsspannung mit Wechselspannungsanteil ist. Hingegen ist bei Einsatz eines pnp-Transistorverstärkers die zweite Versorgungsspannung eine konstante positive Versorgungsspannung und die erste Versorgungsspannung mit dem Wechselspannungsanteil ist eine negative Versorgungsspannung. Weiterhin können auch eine normale oder eine komplementäre Darlingtonschaltung in npn- oder pnp-Bauform verwendet werden.

Bevorzugt werden Bipolartransistoren eingesetzt, wobei grundsätzlich aber auch die Verwendung von Feldeffekttransistoren möglich ist.

Die Auswertung der Spannung über der Messkapazität kann durch Bestimmen von zeitlichen Mittelwerten der Spannung während dem Ladevorgang und dem Entladevorgang der Messkapazität erfolgen. Hierzu erfindungsgemäß vorgesehen, dass die Elektronikmittel zum Gleichrichten eines Signals am Ausgang des Verstärkers eine Gleichrichterschaltung umfassen und dass als Bezugspotenzial für die Gleichrichterschaltung die erste Versorgungsspannung des Verstärkers verwendet wird.

Ein solches gleichgerichtetes Signal entspricht gerade dem zeitlichen Mittelwert der Spannung an der Messkapazität. Dabei ist bedeutsam, dass eine Gleichrichtung getrennt für den Ladevorgang und den Entladevorgang durchgeführt wird. Hierzu kann vorgesehen sein, dass die Gleichrichterschaltung ein Synchrongleichrichter ist und dass der Synchrongleichrichter mit der Ladespannung gesteuert ist. Vorteilhafterweise ist zudem der Spannungsabfall, der mit einer Gleichrichtung verbunden ist, bei einem Synchrongleichrichter mit Analogschaltern oder Feldeffekttransistoren besonders gering.

Zweckmäßigerweise kann vorgesehen sein, dass die Elektronikmittel zum Erzeugen eines analogen Ausgangssignals oder eines Schaltsignals aus Spannungsmittelwerten, die von der Gleichrichterschaltung ausgegeben werden, eingerichtet sind und dass das analoge Ausgangssignal oder das Schaltsignal am Sensorausgang ausgegeben wird. Das analoge Ausgangssignal kann beispielsweise eine Differenz der beiden Spannungsmittelwerte sein, die dem Ladevorgang und dem Entladevorgang der Messkapazität entsprechen.

Das Schaltsignal kann beispielsweise durch Vergleichen der Spannungsmittelwerte mit Schwellwerten oder durch einen Vergleich der Differenz der beiden Spannungsmittelwerte mit einem Schwellwert erfolgen. Hierzu ist erfindungsgemäß vorgesehen sein, dass die Elektronikmittel einen ersten Komparator zum Vergleichen des Ausgangssignals der Gleichrichterschaltung mit einem Schwellwert umfassen und dass am Sensorausgang ein Schaltsignal ausgegeben wird, welches vom Schaltsignal des ersten Komparators abgeleitet wird.

Das Bezugspotenzial für den Ausgang des ersten Komparators ist erfindungsgemäß die erste Versorgungsspannung. Erfindungsgemäß ist ein zweiter Komparator vorhanden, für dessen Ausgang das Bezugspotenzial das Erdpotenzial ist, und das Schaltsignal des ersten Komparators wird so an den zweiten Komparator geleitet, dass der Ausgang des zweiten Komparators nicht mit dem Takt der Ladespannung alterniert. Hierdurch wird ein kostengünstiger Sensoraufbau erreicht. Hierzu ist erfindungsgemäß eine Signalübertragungsschaltung vorhanden, welche das Schaltsignal des ersten Komparators an den zweiten Komparator überträgt. Dabei bezieht die Signalübertragungsschaltung erfindungsgemäß das Schaltsignal des ersten Komparators auf ein Gleichspannungspotenzial, insbesondere auf das Massepotenzial, so dass das Ausgangssignal des zweiten Komparators nicht mit der Frequenz der Ladespannung alterniert.

Bei einer bevorzugten Variante des erfindungsgemäßen Verfahrens umfassen die Schwingungsperioden der alternierenden Ladespannung jeweils eine erste und eine zweite Ladephase. Während der ersten Ladephase wird die Messkapazität geladen, während sie während der zweiten Ladephase entladen wird. Die alternierende Ladespannung kann beispielsweise eine Rechteckform haben, womit die erste und die zweite Ladephase durch die beiden verschiedenen konstanten Spannungsniveaus der Rechteckspannung gebildet sind. Bei der Verfahrensvariante kann vorgesehen sein, dass mit einer Gleichrichterschaltung für eine der Ladephasen oder für beide Ladephasen jeweils ein Spannungsmittelwert ausgegeben wird oder dass mit einer Gleichrichterschaltung ein Ausgangssignal, das aus den Spannungsmittelwerten der zwei Ladephasen abgeleitet ist, ausgegeben wird. Ein solches Ausgangssignal hängt von der Höhe der Messkapazität ab und enthält deshalb eine Information über das nachzuweisende Objekt.

Bei im Folgenden beschriebenen besonders bevorzugten Ausführungsvarianten des erfindungsgemäßen Verfahrens kann die Störfestigkeit gegenüber äußeren Einwirkungen weiter verbessert werden: Koppelt eine äußere störende Komponente kapazitiv auf den Verstärkereingang, so verändert sie dort die Spannung. Solange eine Störfrequenz dieser Komponente nicht synchron zu dem Arbeitstakt des Gleichrichters ist, wird dessen Gleichrichterausgangsspannung im Mittel nicht verändert, so dass die Messung nicht gestört wird. Ist aber die Störfrequenz synchron zu dem Arbeitstakt des Gleichrichters, so wird die Gleichrichterausgangsspannung verändert und die Messung wird verfälscht. Bei einer Auswertung der Mittelwerte zu verschiedenen Frequenzen oder Phasenlagen der Ladespannung werden dann vorteilhafterweise die Wirkungen einer störenden Komponente mit konstanter Störfrequenz und Phasenlage ausgeblendet. Nachzuweisende Objekte können somit noch zuverlässiger erkannt werden.

Weitere Vorteile und Merkmale der Erfindung werden nachstehend mit Bezug auf die beigefügten schematischen Figuren beschrieben. Hierin zeigen:
- Fig. 1: ein schematisches Schaltbild eines gattungsgemäßen Sensors;
- Fig. 2: einen Graphen der alternierenden Ladespannung, mit der die Sondenelektrode versorgt wird, in Abhängigkeit der Zeit;
- Fig. 3: einen Graphen einer idealisierten Wechselspannung zwischen der Sondenelektrode und einem nachzuweisenden Objekt, wenn keine parasitären Kapazitäten auftreten;
- Fig. 4: einen Graphen einer Wechselspannung zwischen der Sondenelektrode und dem Objekt, wobei der Verlauf der Wechselspannung durch parasitäre Kapazitäten beeinflusst ist;
- Fig. 5: einen Graphen einer ersten Versorgungsspannung, die an einem ersten Versorgungsanschluss eines Verstärkers eines erfindungsgemäßen Sensors angelegt wird, und
- Fig. 6: einen Graphen einer Wechselspannung, die zwischen der Sondenelektrode und dem Objekt anliegt, wobei eine parasitäre Kapazität zwischen Eingang des Verstärkers und erster Versorgungsspannung mit Wechselspannungsanteil liegt;
- Fig.7: ein schematisches Schaltbild eines Ausführungsbeispiels eines nicht zur Erfindung gehörenden Sensors;
- Fig. 8: ein schematisches Schaltbild eines zweiten Ausführungsbeispiels eines nicht zur Erfindung gehörenden Sensors und
- Fig. 9: ein schematisches Schaltbild eines Ausführungsbeispiels eines erfindungsgemäßen Sensors.

Gleiche und gleich wirkende Bestandteile sind in den Figuren in der Regel mit denselben Bezugszeichen gekennzeichnet.

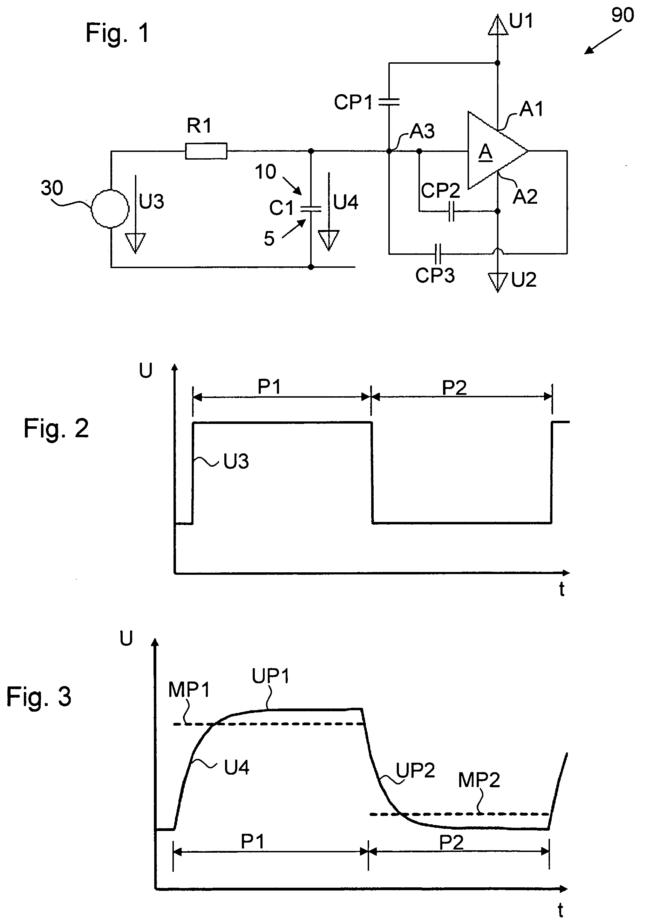

Fig. 1 zeigt ein schematisches Schaltbild eines gattungsgemäßen Sensors 90. Dieser umfasst als wesentliche Komponenten eine Sondenelektrode 10 und einen Verstärker A.

Die Sondenelektrode 10 bildet mit einem nachzuweisenden Objekt 5 eine Messkapazität C1. Die Größe der Messkapazität C1 wird durch Position und Art des Objekts 5 beeinflusst, so dass über die Messkapazität C1 auf die Anwesenheit des Objekts 5 sowie auf einen Abstand zum Objekt 5 geschlossen werden kann.

Der Sensor 90 umfasst außerdem einen Ladegenerator 30, der über einen Ladewiderstand R1 die Sondenelektrode 10 mit einer alternierenden Ladespannung U3 lädt. Das Messobjekt 5 befindet sich hingegen auf Erdpotenzial.

Die Wirkungen der alternierenden Ladespannung U3 und die daraus resultierende Wechselspannung zwischen der Sondenelektrode 10 und dem Messobjekt 5 werden mit Bezug auf die Figuren 2 und 3 erläutert.

Figur 2 zeigt einen Graphen, bei dem schematisch die alternierende Ladespannung U3 auf der Ordinate U gegen die Zeit t auf der Abszisse aufgetragen ist. Die alternierende Ladespannung U3 hat eine Rechteckform, wobei eine Periode der Ladespannung U3 zumindest eine erste und eine zweite Ladephase P1, P2 mit unterschiedlichem elektrischen Potenzial umfasst.

Durch die alternierende Ladespannung U3 liegt zwischen der Sondenelektrode 10 und dem Objekt 5 eine Wechselspannung U4 an, welche schematisch in Figur 3 in Abhängigkeit der Zeit t dargestellt ist. Während der ersten Ladephase P1 wird die Sondenelektrode 10 gemäß der Kurve UP1 auf einen hohen Spannungswert bezüglich des Objekts 5 geladen. Dabei ist der zeitliche Verlauf der Wechselspannung U4 nicht rechteckförmig, sondern abgeflacht. Je größer die Messkapazität C1 ist, desto größer ist die Zeitkonstante des Ladevorgangs, das heißt desto flacher ist der Anstieg der Kurve UP1. In der zweiten Ladephase P2 fällt die Wechselspannung U4 an der Sondenelektrode 10 gemäß der Kurve UP2 auf einen niedrigeren Wert. Auch hier wird abhängig von der Größe der Messkapazität C1 die Kurve UP2 abgeflacht.

In Figur 3 sind zudem Mittelwerte MP1 und MP2 der Wechselspannung U4 während der Ladephasen P1 und P2 gezeigt. Je größer die Messkapazität C1 ist, desto flacher verlaufen die Kurven UP1 und UP2 und desto kleiner ist der Abstand zwischen den beiden Mittelwerten MP1 und/oder MP2. Somit kann aus den Mittelwerten MP1 und MP2 oder auch aus der Differenz zwischen MP1 und MP2 auf die Anwesenheit oder den Abstand eines Objekts 5 geschlossen werden.

Um die Wechselspannung U4 oder ihren zeitlichen Mittelwert möglichst genau zu bestimmen, ist die Sondenelektrode 10 mit einem Eingang des Verstärker A verbunden. Durch den Verstärker A kann es bei herkömmlichen Sensoren 90 und Messverfahren zu Störeffekten kommen, die mit Bezug auf Figur 1 erläutert werden.

Der Verstärker A hat einen ersten Versorgungsanschluss A1, an den eine erste Versorgungsspannung U1 angelegt wird, und einen zweiten Versorgungsanschluss A2, an den eine zweite Versorgungsspannung U2 angelegt wird.

Je nach Aufbau des Verstärkers A sind eine parasitäre Kapazität CP1 zwischen dem ersten Versorgungsanschluss A1 und dem Eingang A3 des Verstärkers A und/oder eine parasitäre Kapazität CP2 zwischen dem zweiten Versorgungsanschluss A2 und dem Eingang A3 vorhanden. Zudem entsteht zwischen dem Ausgang des Verstärkers A und dem Eingang A3 eine weitere parasitäre Kapazität CP3.

Sind die erste Vorsorgungsspannung U1 und die zweite Versorgungsspannung U2 jeweils eine Gleichspannung, so wirken die parasitären Kapazitäten. Die Sondenelektrode 10 ist wie auch die parasitären Kapazitäten CP1, CP2 und CP3 mit dem Eingang A3 des Verstärkers verbunden. Deshalb wird ein Ladevorgang der Messkapazität C1, die mit der Sondenelektrode 10 und dem Objekt 5 gebildet ist, durch die parasitären Kapazitäten CP1, CP2 und CP3 beeinflusst. Folglich ändert sich der zeitliche Verlauf der Wechselspannung U4 an der Messkapazität C1.

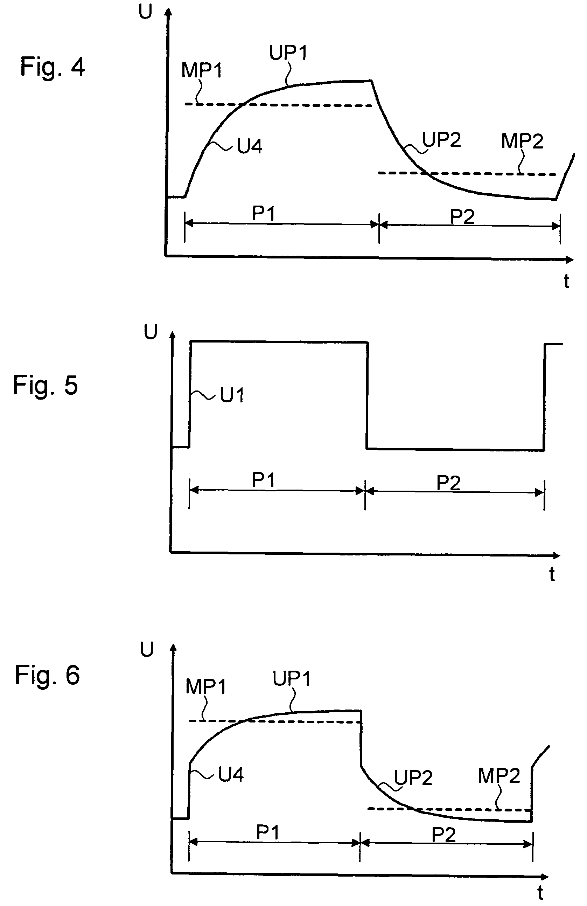

Figur 4 zeigt einen Graphen, in dem die Wechselspannung U4 schematisch gegen die Zeit t aufgetragen ist. Durch die Wirkungen der parasitären Kapazitäten CP1, CP2 und CP3 ist der Verlauf der Wechselspannung U4 gegenüber dem Fall aus Figur 3 weiter abgeflacht. Der Abstand der Mittelwerte MP1 und MP2 der Wechselspannung U4 während den beiden Ladephasen P1 und P2 ist deshalb kleiner. Die parasitären Kapazitäten CP1, CP2 und CP3 beeinflussen also die Mittelwerte MP1 und MP2. Ein Rückschluss auf die Größe der Messkapazität 10 und somit auf die Anwesenheit oder den Abstand eines Objekts 5 wird daher verfälscht.

Erfindungsgemäß wird die Auswirkung der parasitären Kapazitäten CP1, CP2 und CP3 weitestgehend unwirksam gemacht, so dass ein Messergebnis nicht oder nur kaum durch die parasitären Kapazitäten CP1, CP2 und CP3 beeinflusst wird.

Mit der folgenden Maßnahme wird die Auswirkung der parasitären Kapazität CP1 unwirksam gemacht:
An den ersten Versorgungsanschluss A1 des Verstärkers A wird eine Versorgungsspannung U1 angelegt, die einen Wechselspannungsanteil aufweist. Ein Graph einer solchen Versorgungsspannung U1 ist in Figur 5 gezeigt. Der Wechselspannungsanteil der Versorgungsspannung U1 hat eine Rechteckform und stimmt in Periodenlänge, Amplitude und Phasenlage mit der Ladespannung überein. Zudem umfasst die Versorgungsspannung U1 einen Gleichspannungsanteil, dessen Größe ausreichend für den Betrieb des Verstärkers A gewählt ist.

Durch diese alternierende erste Versorgungsspannung U1 wird der Verlauf der Wechselspannung U4 an der Sondenelektrode 10 verändert. Figur 6 zeigt den Verlauf der Wechselspannung U4, wobei während der ersten Ladephase P1 wiederum ein steigender Abschnitt UP1 der Wechselspannung U4 vorliegt, wohingegen während der zweiten Ladephase P2 ein abfallender Abschnitt UP2 der Wechselspannung U4 vorliegt. Ein kapazitiver Spannungsteiler wird gebildet aus der parasitären Kapazität CP1 und der Messkapazität. An den Übergängen zwischen den Ladephasen P1 und P2 macht die erste Versorgungsspannung des Verstärkers U1 jeweils einen Spannungssprung. Der Spannungssprung von U1 wird mit dem Teilungsfaktor des kapazitiven Spannungsteilers auf die Messkapazität gekoppelt.

Hierdurch wird der Mittelwert MP1 während der ersten Ladephase P1 angehoben. Die durch die parasitäre Kapazität CP1 bedingte Absenkung des Mittelwerts MP1, die zu Figur 4 beschrieben wurde, wird dadurch gerade kompensiert, so dass kein störenden Einfluss der parasitären Kapazität CP1 auf den Mittelwert MP1 entsteht.

In analoger Weise bewirkt während der zweiten Ladephase P2 die sprunghafte Änderung ein Absenken des Mittelwerts MP2, womit auch während der zweiten Ladephase P2 eine Auswirkung der parasitären Kapazität CP1 auf den Mittelwert MP2 ausgeglichen wird.

Vorteilhafterweise können so besonders genaue Rückschlüsse auf die Messkapazität und damit auf Anwesenheit und/oder Position eines Objekts gezogen werden.

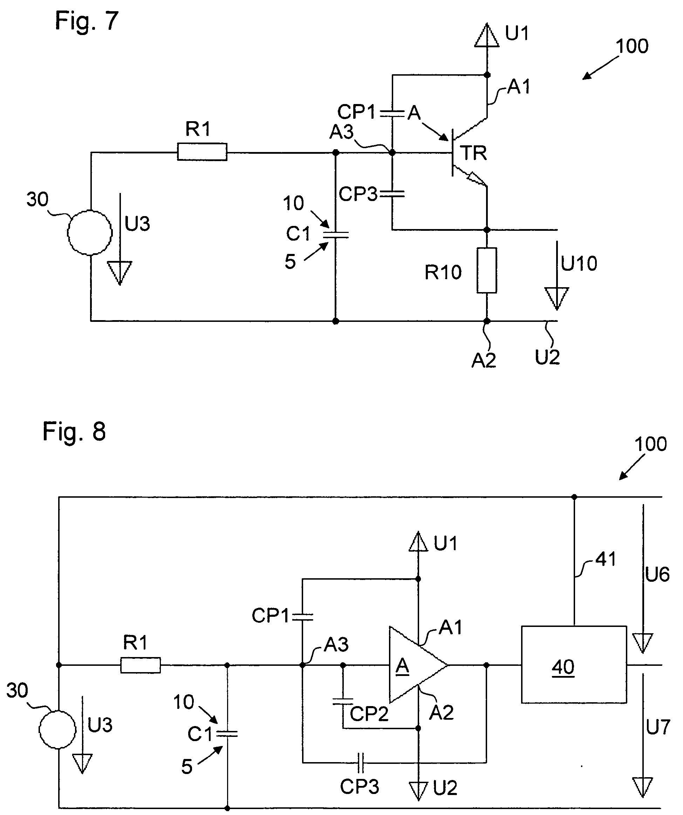

Mit der folgenden Maßnahme wird die parasitäre Kapazität CP2 verhindert:
Ein schematisches Schaltbild eines nicht zur Erfindung gehörenden Sensors 100 ist in Figur 7 gezeigt. Wie zu dem Sensor 90 aus Figur 1 beschrieben, wird auch hier eine Messkapazität C1 aus einer Sondenelektrode 10 und einem nachzuweisenden Objekt 5 gebildet. Ebenso ist in diesem Fall an der Messkapazität C1 über einen Ladewiderstand R1 eine Ladespannung U3 angeschlossen.

Der Verstärker A ist bei dieser Ausführung als Transistorverstärker gebildet. Dieser umfasst einen Bipolartransistor TR, der hier ein npn-Transistor ist, und einen Widerstand R10. An die Basis des Transistors TR ist die Sondenelektrode 10 angeschlossen. An den Emitter des Transistors TR ist der Widerstand R10 angeschlossen. Mit seiner anderen Seite liegt der Widerstand R10, wie auch das nachzuweisende Objekt 5, auf Masse oder Erdpotenzial. Über den Widerstand R10 fällt eine Spannung U10 ab, deren Höhe von der Wechselspannung U4 zwischen der Sondenelektrode 10 und dem Objekt 5 abhängt.

An den Kollektor des Transistors TR ist die erste Versorgungsspannung U1 angelegt, die bei dem vorliegenden Ausführungsbeispiel eine positive Versorgungsspannung ist. Diese hat einen Gleichspannungsanteil und einen Wechselspannungsanteil, wie in Figur 5 dargestellt.

Jeder integrierte Verstärker besitzt eine parasitäre Kapazität CP2 zwischen Eingang und negativer Versorgungsspannung. Bei dem hier beschriebenen Transistorverstärker ist dies nicht der Fall. Daher ist es nicht notwendig, die Auswirkung von CP2 unwirksam zu machen. Die negative Versorgungsspannung kann deshalb konstant bleiben, im vorliegenden Fall auf Erdpotenzial.

Bei einer weiteren, nicht dargestellten, Ausführungsform ist der Transistor ein pnp-Transistor. Bei diesem gibt es keine parasitäre Kapazität zwischen der positiven Versorgungsspannung und dem Verstärkereingang, wohl aber zwischen der negativen Versorgungsspannung und dem Verstärkereingang. Daher ist in diesem Fall die erste Versorgungsspannung, die den Wechselspannungsanteil aufweist, die negative Versorgungsspannung des Transistors. Die positive Versorgungsspannung hingegen ist eine Gleichspannung.

Bei einer alternativen Ausführungsvariante ist der Verstärker A durch eine Darlingtonschaltung oder eine komplementäre Darlingtonschaltung gebildet, wobei wiederum eine npn- oder pnp-Bauweise verwendet werden kann.

Mit der folgenden Maßnahme wird die Auswirkung der parasitären Kapazität CP3 unwirksam gemacht:
Der Verstärker A hat die Wechselspannungsverstärkung eins. Durch eine parasitäre Kapazität CP3 zwischen Eingang und Ausgang des Verstärkers kann dann kein Strom fließen. Die Kapazität CP3 wirkt sich nicht aus.

In Figur 8 ist ein weiteres Ausführungsbeispiel eines nicht zur Erfindung gehörenden Sensors 100 gezeigt.

Dieser ist wiederum weitgehend gleich zu dem Sensor 90 aus Figur 1 aufgebaut. Im Unterschied zu diesem hat die erste Versorgungsspannung U1 einen Wechselspannungsanteil, während die zweite Versorgungsspannung U2 eine Gleichspannung ist.

Bei der Ausführungsform aus Figur 8 ist zusätzlich eine Gleichrichterschaltung 40 vorhanden, die an den Ausgang des Verstärkers A angeschlossen ist. Die Gleichrichterschaltung 40 ist hier ein Synchrongleichrichter, welcher über ein Steuersignal 41 von der Ladespannung gesteuert wird. Am Ausgang der Gleichrichterschaltung 40 wird der Mittelwert der Spannung über der Messkapazität jeweils für die erste und die zweite Ladephase P1 und P2 der Ladespannung ausgegeben. Somit gibt der Synchrongleichrichter die in Figur 6 gezeigten Spannungsmittelwerte MP1 und MP2, oder zu diesen Mittelwerten proportionale Spannungen, aus.

Alternativ kann der Gleichrichter 40 so ausgeführt werden, dass nur einer der Spannungsmittelwerte MP1 und MP2 ausgegeben wird.

Als Bezugspotenzial der Gleichrichterschaltung 40 kann die negative oder die positive Versorgungsspannung des Verstärkers gewählt werden oder auch ein aus diesen abgeleitetes Bezugspotential. In Figur 8 sind die Gleichrichterspannung U6 und Gleichrichterspannung U7 als Beispiel gezeigt.

Alternativ zu der beschriebenen Gleichrichterschaltung 40 kann auch ein Gleichrichter mit zwei Ausgängen vorhanden sein, an denen die beiden Mittelwerte MP1 und MP2 oder diesen entsprechende Signale ausgegeben werden.

Bei einer weiteren Alternative wird an einem Ausgang der Gleichrichterschaltung 40 die Differenz der Mittelwerte MP1 und MP2 oder die Differenz von Signalen, die diesen Mittelwerten entsprechen, ausgegeben.

Die Auswertung der Ausgangsspannung der Gleichrichterschaltung 40 ist in verschiedener Weise möglich. So kann die Ausgangsspannung der Gleichrichterschaltung 40 mit einem Verstärker verstärkt, verschoben, skaliert und/oder linearisiert werden und darauf an einem Ausgang des Sensors 100 ausgegeben werden.

Alternativ kann die Ausgangsspannung der Gleichrichterschaltung 40 einem Analog-Digital-Wandler zugeführt werden und anschließend mit einem Mikroprozessor zu einem Ausgangssignal verarbeitet werden, welches wiederum als analoges Signal oder als Schaltsignal ausgegeben werden kann.

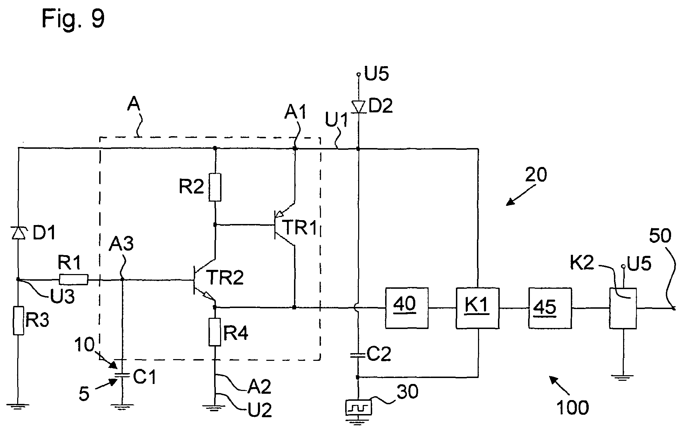

Weiterhin ist es möglich, die Ausgangsspannung der Gleichrichterschaltung 40 mittels eines Komparators mit einer Schwellspannung zu vergleichen. Ein Prinzipschaltbild einer solchen Ausführungsform eines erfindungsgemäßen Sensors 100 ist in Figur 9 gezeigt.

Hier sind als wesentliche Komponenten des erfindungsgemäßen Sensors 100 insbesondere der Verstärker A, die Sondenelektrode 10, die Gleichrichterschaltung 40 sowie ein Generator 30 gezeigt.

Der Generator 30 erzeugt eine Wechselspannung, die beispielsweise zwischen 0V und 5V rechteckförmig wechselt. Diese Spannung wird sowohl zum Aufladen der Sondenelektrode als auch zur Spannungsversorgung des Verstärkers genutzt. Daher stellt der Generator 30 gleichzeitig einen Ladegenerator und einen Versorgungsspannungsgenerator dar. Dieser Generator oder Frequenzgenerator 30 ist über einen Haltekondensator C2 mit dem ersten Versorgungsanschluss A1 des Verstärkers A verbunden. An dem ersten Versorgungsanschluss A1 ist außerdem eine Gleichspannungsversorgung U5 über eine Diode D2 angeschlossen.

Während einer negativen Halbwelle der Wechselspannung des Frequenzgenerators 30 wird deshalb der erste Versorgungsanschluss A1 auf den Spannungswert der Gleichspannungsversorgung U5 gebracht. Dieser Wert kann durch einen Spannungsabfall an der Diode D2 geringfügig gesenkt sein.

Zudem wird während der negativen Halbwelle der Wechselspannung des Frequenzgenerators 30 der Haltekondensator durch die Gleichspannungsversorgung U5 aufgeladen. Während einer positiven Halbwelle der Wechselspannung des Frequenzgenerators 30 wird nun am Punkt A1 eine Spannung erzeugt, die der Summe der Gleichspannung der Gleichspannungsversorgung U5 und der Wechselspannungsamplitude des Frequenzgenerators 30 entspricht. Bevorzugt ist die Amplitude der Wechselspannung des Frequenzgenerators 30 gleich der Gleichspannungshöhe der Gleichspannungsversorgung U5, so dass am Punkt A1 eine Spannungsverdopplung eintritt. Liefert die Gleichspannungsversorgung U5 beispielsweise 5V und wechselt die Wechselspannung des Frequenzgenerators 30 zwischen 0V und 5V, so liegt an dem ersten Versorgungsanschluss A1 eine Versorgungsspannung an, die zwischen 5V und 10V wechselt, siehe auch Fig. 6.

Der zweite Versorgungsanschluss A2 ist mit Masse verbunden und liegt somit bei 0V. An dem zweiten Versorgungsanschluss A2 muss nicht eine Wechselspannung angelegt werden, da aufgrund des Aufbaus des Verstärkers A keine parasitäre Kapazität zwischen dem Verstärkereingang A3 und dem zweiten Versorgungsanschluss A2 kompensiert werden muss.

Ein bevorzugter Aufbau des Verstärkers A ist in Figur 9 detaillierter dargestellt. Dieser umfasst eine komplementäre Darlingtonschaltung mit einem pnp-Transistor TR1 und einem npn-Transistor TR2. An den Emitter des pnp-Transistors TR1 ist die Versorgungsspannung mit Wechselspannungsanteil angelegt. Parallel zu Emitter und Basis des pnp-Transistors TR1 befindet sich ein Widerstand R2. Der Kollektor des npn-Transistors TR2 ist an die Basis des pnp-Transistors TR1 angeschlossen. Der Emitter des npn-Transistors TR2 ist mit dem Kollektor des pnp-Transistors TR1 verbunden.

An die Basis des npn-Transistors TR2 ist die Sondenelektrode 10 angeschlossen. Diese Verknüpfung ist in Figur 9 als Verstärkereingang mit A3 gekennzeichnet.

Die Ladespannung der Sondenelektrode 10 wird hier aus der ersten Versorgungsspannung des Verstärkers erhalten. Vorteilhafterweise kann so bei kostengünstigem Aufbau erreicht werden, dass die Ladespannung und die erste Versorgungsspannung in Frequenz und Phasenlage übereinstimmen.

Hierzu ist der erste Versorgungsanschluss des Verstärkers, an dem die erste Versorgungsspannung anliegt, über eine Zener-Diode D1 und einen Widerstand R1 mit der Sondenelektrode 10 und mit dem Verstärkereingang A3 verbunden. Zwischen der Zener-Diode D1 und dem Widerstand R1 ist ein weiterer Widerstand R3 angeschlossen, der mit Masse verbunden ist.

Die von dem Verstärker A ausgegebene Spannung wird an die Gleichrichterschaltung 40 gegeben, wobei die erste Versorgungsspannung des Verstärkers, die den Wechselspannungsanteil aufweist, oder ein daraus abgeleitetes Bezugspotential als Bezugspotenzial für den Ausgang des Verstärkers dient.

Für die gleichgerichtete Ausgangsspannung, die von der Gleichrichterschaltung 40 ausgegeben wird, ist weiterhin die erste Versorgungsspannung des Verstärkers, die den Wechselspannungsanteil aufweist, das Bezugspotenzial.

Diese gleichgerichtete Ausgangsspannung wird an einen Komparator K1 gegeben, der die gleichgerichtete Ausgangsspannung mit einer einstellbaren Referenzspannung vergleicht. Liegt die Ausgangsspannung unterhalb der Referenzspannung, so wird als Schaltsignal die vom Frequenzgenerator 30 gelieferte Spannung ausgegeben, im Beispiel also je nach Ladephase P1 oder P2 eine Spannung von 0V oder 5V. Übersteigt hingegen die gleichgerichtete Ausgangsspannung die Referenzspannung, so wird als Schaltsignal die am ersten Versorgungsanschluss des Verstärkers anliegende Spannung ausgegeben, im vorliegenden Beispiel also 5V oder 10V. Die Wirkrichtung des Komparators kann auch getauscht sein. Dann wird als Schaltsignal die vom Frequenzgenerator 30 gelieferte Spannung ausgegeben, wenn die Referenzspannung unterhalb der Ausgangsspannung des Gleichrichters liegt.

An den Ausgang des Komparators K1 ist eine Signalübertragungsschaltung 45 geschaltet, die das vom Komparator K1 ausgegebene Schaltsignal auf Masse, also 0V, bezieht.

Auf die Signalübertragungsschaltung 45 folgt ein zweiter Komparator K2, der das von der Signalübertragungsschaltung 45 kommende Schaltsignal mit einem Schwellwert vergleicht und abhängig vom Ergebnis des Vergleichs entweder ein Schaltsignal mit 0V oder mit der Gleichspannung, die von der Gleichspannungsversorgung U5 bereitgestellt wird, ausgibt, im vorliegenden Beispiel also 5V. Dieses Schaltsignal wird an einen Ausgang 50 des Sensors 100 gegeben.

Vorteilhafterweise wird dieses Schaltsignal abhängig von äußerst geringen Kapazitätsänderungen an der Sondenelektrode erzeugt. Dies kann mit dem erfindungsgemäßen Sensor dadurch erreicht werden, dass keine parasitären Kapazitäten am Verstärker wirken. Hierzu wird an einem der Versorgungsspannungsanschlüsse des Verstärkers eine Versorgungsspannung mit Wechselspannungsanteil angelegt. An dem anderen Versorgungsspannungsanschluss wird hingegen eine Gleichspannung angelegt, da zwischen diesem Versorgungsspannungsanschluss und dem Verstärkereingang aufgrund des Aufbaus des Verstärkers keine parasitäre Kapazität auftritt. Geringe Kapazitätsänderungen durch ein nachzuweisendes Objekt können so besonders sicher erkannt werden.

### Bezugszeichenliste:

- 5: Objekt
- 10: Sondenelektrode
- 20, K1, K2: elektronische Verarbeitungsmittel
- 30: Generator
- 40: Gleichrichterschaltung
- 41: Steuersignal der Gleichrichterschaltung
- 45: Signalübertragungsschaltung
- 50: Sensorausgang
- 90: gattungsgemäßer Sensor
- 100: erfindungsgemäßer Sensor
- A: Verstärker
- A1: erster Versorgungsanschluss
- A2: zweiter Versorgungsanschluss
- A3: Verstärkereingang
- K1: erster Komparator
- K2: zweiter Komparator
- R1: Ladewiderstand
- R2, R3, R4: Widerstände
- D1: Zener-Diode
- D2: Diode
- CP1, CP2, CP3: parasitäre Kapazität
- C1: Messkapazität
- C2: Haltekondensator
- TR, TR1, TR2: Transistoren des Verstärkers A
- U1: erste Versorgungsspannung
- U2: zweite Versorgungsspannung
- U3: Ladespannung
- U4: Spannung zwischen Sondenelektrode und Objekt
- U5: Versorgungsgleichspannung
- U6, U7: Gleichrichterspannungen
- U10: Verstärkerausgangsspannung
- P1, P2: erste und eine zweite Ladephase der alternierenden Ladespannung U3
- UP1, UP2: Verlauf der Spannung U4
- MP1, MP2: Spannungsmittelwerte der Spannung U4 während der zwei Ladephasen P1 und P2

## Patentansprüche

1. Sensor zum Nachweisen eines Objekts (5)
mit einer Sondenelektrode (10) zum Bilden einer Messkapazität (C1) mit dem nachzuweisenden Objekt (5),
mit einem Ladegenerator (30) zum Erzeugen einer alternierenden Ladespannung (U3), wobei die Sondenelektrode (10) mittels der alternierenden Ladespannung (U3) geladen wird,
mit einem Verstärker (A) zum Verstärken einer Spannung über der Messkapazität (C1),
wobei der Verstärker (A) einen ersten Versorgungsanschluss (A1) und einen zweiten Versorgungsanschluss (A2) aufweist,
mit Elektronikmitteln (20) zum Verarbeiten von Signalen, die an einem Ausgang des Verstärkers (A) ausgegeben werden, zu mindestens einem Ausgangssignal und
mit mindestens einem Sensorausgang (50) zum Ausgeben des mindestens einen Ausgangssignals,
wobei an dem zweiten Versorgungsanschluss (A2) als eine zweite Versorgungsspannung (U2) eine Gleichspannung angelegt ist,
wobei an dem ersten Versorgungsanschluss (A1) eine erste Versorgungsspannung (U1) mit einem Wechselspannungsanteil angelegt ist, wobei zum Erzeugen des Wechselspannungsanteils ein Versorgungsspannungsgenerator (30) vorhanden ist,
wobei die Elektronikmittel (20) zum Gleichrichten eines Signals am Ausgang des Verstärkers (A) eine Gleichrichterschaltung (40) umfassen,
wobei das Bezugspotenzial der Gleichrichterschaltung (40) die erste Versorgungsspannung (U1) des Verstärkers (A) ist,
wobei die Elektronikmittel (20) einen ersten Komparator (K1) zum Vergleichen des Ausgangssignals der Gleichrichterschaltung (40) mit einem Schwellwert umfassen und
wobei ein Ausgangssignal des ersten Komparators (K1) als Schaltsignal, insbesondere an den Sensorausgang (50), ausgegeben wird,
wobei das Bezugspotenzial für den Ausgang des ersten Komparators (K1) die erste Versorgungsspannung (U1) ist,
wobei ein zweiter Komparator (K2) vorhanden ist, für dessen Ausgang Erdpotenzial das Bezugspotenzial ist, und
wobei eine Signalübertragungsschaltung (45) zum Übertragen des Schaltsignals des ersten Komparators (K1) an den zweiten Komparator (K2) vorhanden ist, wobei die Signalübertragungsschaltung (45) das Schaltsignal des ersten Komparators (K1) auf ein Gleichspannungspotenzial bezieht, so dass das Ausgangssignal des zweiten Komparators (K2) nicht mit der Frequenz der Ladespannung (U3) alterniert.

2. Sensor nach Anspruch 1,
wobei der Ladegenerator (30) und der Versorgungsspannungsgenerator (30) durch ein und denselben Generator (30) gebildet sind und
wobei der Wechselspannungsanteil der ersten Versorgungsspannung (U1) durch die alternierende Ladespannung (U3) bestimmt ist.

3. Sensor nach Anspruch 1 oder 2,
wobei die erste Versorgungsspannung (U1) zusätzlich mit einem Gleichspannungsanteil (U5) gebildet ist, der zum Betreiben des Verstärkers (A) in dessen Arbeitsbereich von Erdpotenzial verschieden ist.

4. Sensor nach einem der Ansprüche 1 bis 3,
**dadurch gekennzeichnet,**
wobei die Amplitude der Spannung bezüglich Erdpotenzial, die mittels der Ladespannung (U3) an die Sondenelektrode (10) angelegt ist, maximal 20% abweichend, insbesondere gleich, zu der Amplitude des Wechselspannungsanteils der ersten Versorgungsspannung (U1) ist.

5. Sensor nach einem der Ansprüche 1 bis 4,
wobei die an dem zweiten Versorgungsanschluss (A2) anliegende zweite Versorgungsspannung (U2) gleich dem Erdpotenzial ist.

6. Sensor nach Anspruch 5,
wobei zum Vermeiden einer parasitären Kapazität (CP2) zwischen dem zweiten Versorgungsanschluss (A2) und dem Verstärkereingang (A3) der Verstärker (A) ein Transistorverstärker in Kollektorschaltung, insbesondere eine Darlingtonschaltung in Kollektorschaltung oder eine komplementäre Darlingtonschaltung in Kollektorschaltung, ist.

7. Sensor nach einem der Ansprüche 1 bis 6,
wobei die Gleichrichterschaltung (40) ein Synchrongleichrichter ist und
wobei der Synchrongleichrichter mit der Ladespannung (U3) gesteuert ist.

8. Sensor nach einem der Ansprüche 1 bis 7,
wobei die Elektronikmittel (20) zum Erzeugen eines analogen Ausgangssignals oder eines Schaltsignals aus Spannungsmittelwerten (MP1, MP2), die von der Gleichrichterschaltung (40) ausgegeben werden, eingerichtet sind und wobei das analoge Ausgangssignal oder das Schaltsignal am Sensorausgang (50) ausgegeben wird.

9. Verfahren zum Nachweisen eines Objekts (5) mit einem Sensor nach einem der Ansprüche 1 bis 8,
bei dem eine Messkapazität (C1) mittels einer Sondenelektrode (10) und des nachzuweisenden Objekts (5) gebildet wird,
bei dem die Sondenelektrode (10) mittels einer alternierenden Ladespannung (U3) geladen wird,
bei dem mit einem Verstärker (A) eine Spannung über der Messkapazität (C1) verstärkt wird,
bei dem Signale, die an einem Ausgang des Verstärkers (A) ausgegeben werden, zu mindestens einem Ausgangssignal verarbeitet werden und
bei dem das mindestens eine Ausgangssignal ausgegeben wird,
wobei an einem zweiten Versorgungsanschluss (A2) des Verstärkers (A) als eine zweite Versorgungsspannung (U2) eine Gleichspannung angeschlossen wird und
wobei an einem ersten Versorgungsanschluss (A1) des Verstärkers (A) eine erste Versorgungsspannung (U1) mit einem Wechselspannungsanteil angeschlossen wird, wobei der Wechselspannungsanteil mit einem Versorgungsspannungsgenerator (30) erzeugt wird.

10. Verfahren nach Anspruch 9,
wobei die Schwingungsperioden der alternierenden Ladespannung (U3) jeweils eine erste und eine zweite Ladephase (P1, P2) umfassen und wobei mit einer Gleichrichterschaltung (40) für die zwei Ladephasen (P1, P2) jeweils ein Spannungsmittelwert (MP1, MP2) ausgegeben wird oder wobei mit einer Gleichrichterschaltung (40) ein Ausgangssignal, das aus beiden Spannungsmittelwerten (MP1, MP2) zu den zwei Ladephasen (P1, P2) abgeleitet wird oder aus einem Spannungsmittelwert (MP1, MP2) zu einer der zwei Ladephasen (P1, P2) abgeleitet wird, ausgegeben wird.

## Claims

1. A sensor for detecting an object (5) comprising
a probe electrode (10) for forming a measuring capacitance (C1) with the object (5) to be detected,
a charge generator (30) for generating an alternating charging voltage (U3), wherein the probe electrode (10) is charged by means of the alternating charging voltage (U3),
an amplifier (A) for amplifying a voltage across the measuring capacitance (C1), wherein said amplifier (A) includes a first supply connection (A1) and a second supply connection (A2),
electronic means (20) for processing signals that are outputted at an output of the amplifier (A) to form at least one output signal and
at least one sensor output (50) for outputting the at least one output signal,
wherein
a second supply voltage (U2) in the form of a DC voltage is connected to said second supply connection (A2) and
a first supply voltage (U1) having an AC voltage portion is connected to said first supply connection (A1),
wherein a supply voltage generator (30) is available for generating said AC voltage portion,
said electronic means (20) comprises a rectifier circuit (40) for rectifying a signal at the output of said amplifier (A) and
said first supply voltage (U1) of said amplifier (A) serves as the reference potential of said rectifier circuit (40),
said electronic means (20) comprises a first comparator (K1) for comparing the output signal of the rectifier circuit (40) with a threshold value and
an output signal of said first comparator (K1) is outputted as a switching signal, more particularly to said sensor output (50),
the reference potential for the output of said first comparator (K1) is said first supply voltage (U1),
a second comparator (K2) is available, for the output of which the ground potential is the reference potential, and
a signal transmission circuit (45) is available for transmitting said switching signal of said first comparator (K1) to said second comparator (K2), wherein said signal transmission circuit (45) relates said switching signal of said first comparator (K1) to a DC voltage potential so that the output signal of said second comparator (K2) does not alternate at the frequency of said charging voltage (U3).

2. The sensor as defined in claim 1,
wherein said charge generator (30) and said supply voltage generator (30) are formed by one and the same generator (30) and
wherein said AC voltage portion of said first supply voltage (U1) is determined by said alternating charging voltage (U3).

3. The sensor as defined in claim 1 or claim 2,
wherein said first supply voltage (U1) is additionally provided with a DC voltage portion (U5) which, in order to operate said amplifer (A) within its operating range, differs from ground potential.

4. The sensor as defined in any one of claims 1 to 3,
wherein with reference to ground potential, the voltage amplitude applied by said charging voltage (U3) at said probe electrode (10) deviates by a maximum of 20% from, or more particularly is equal to, the amplitude of said AC voltage portion of said first supply voltage (U1).

5. The sensor as defined in any one of claims 1 to 4,
wherein said second supply voltage (U2) present at said second supply connection (A2) is equal to ground potential.

6. The sensor as defined in claim 5,
wherein in order to inhibit a parasitic capacitance (CP2) between said second supply connection (A2) and said amplifier input (A3), said amplifier (A) is a transistor amplifier in common collector circuit, more particularly a common collector Darlington circuit or a complementary common collector Darlington circuit.

7. The sensor as defined in any one of the claims 1 to 6,
wherein said rectifier circuit (40) is a synchronous rectifier and
said synchronous rectifier is controlled by said charging voltage (U3).

8. The sensor as defined in any one of the claims 1 to 7,
wherein said electronic means (20) are configured to generate an analog output signal or a switching signal based on voltage mean values (MP1, MP2) which are outputted from said rectifier circuit (40), and
the analog output signal or the switching signal are outputted at said sensor output (50).

9. A method for detecting an object (5) by means of a sensor as defined in any one of claims 1 to 8,
wherein a measuring capacitance (C1) is formed by means of a probe electrode (10) and the object to be detected,
wherein the probe electrode (10) is charged by means of an alternating charging voltage (U3),
wherein a voltage across the measuring capacitance (C1) is amplified by an amplifier (A),
wherein signals outputted at an output of said amplifier (A) are processed to form at least one output signal and
wherein said at least one output signal is outputted,
wherein a second supply voltage (U2) in the form of a DC voltage is connected to a second supply connection (A2) of said amplifier (A) and
a first supply voltage (U1) having an AC voltage portion is connected to a first supply connection (A1) of said amplifier (A), wherein said AC voltage portion is generated by a supply voltage generator (30).

10. The method as defined in claim 9,
wherein each of the oscillation periods of the alternating charging voltage (U3) comprises a first and a second charge phase (P1, P2) and
for each of the two charge phases (P1, P2) a mean voltage value (MP1, MP2) is outputted by a rectifier circuit (40), or wherein an output signal derived from the two mean voltage values (MP1, MP2) relating to the two charge phases (P1, P2) or from one mean voltage value (MP1, MP2) relating to one of the two charge phases (P1, P2) is outputted by a rectifier circuit (40).

## Revendications

1. Capteur destiné à la détection d'un objet (5),
avec une électrode sonde (10) pour former une capacité de mesure (C1) avec l'objet (5) à détecter,
avec un générateur de charge (30) pour la production d'une tension alternative de charge (U3), l'électrode sonde (10) étant chargée au moyen de la tension alternative de charge (U3),
avec un amplificateur (A) pour l'amplification d'une tension aux bornes de la capacité de mesure (C1),
l'amplificateur (A) comprenant une première borne d'alimentation (A1) et une deuxième borne d'alimentation (A2),
avec des moyens électroniques (20) pour le traitement de signaux qui ont été produits sur une sortie de l'amplificateur (A), en vue d'au moins un signal de sortie, et
avec au moins une sortie de capteur (50) pour la production d'au moins un signal de sortie,
une tension continue étant appliquée sur la deuxième borne d'alimentation (A2) pour constituer une deuxième tension d'alimentation (U2),
une première tension d'alimentation (U1) avec une composante de tension alternative étant appliquée sur la première borne d'alimentation (A1),
un générateur de tension d'alimentation (30) étant présent pour la génération de la composante alternative de la tension,
les moyens électroniques (20) comprenant un circuit redresseur (40) pour le redressement d'un signal à la sortie de l'amplificateur (A),
le potentiel de référence du circuit redresseur (40) étant la première tension d'alimentation (U1) de l'amplificateur (A),
les moyens électroniques (20) comprenant un premier comparateur (K1) pour la comparaison du signal de sortie du circuit redresseur (40) à une valeur de seuil, et
un signal de sortie du premier comparateur (K1) étant produit, plus particulièrement sur la sortie de capteur (50), pour constituer un signal de commutation, le potentiel de référence pour la sortie du premier comparateur (K1) étant la première tension d'alimentation (U1),
dans lequel un deuxième comparateur (K2) est présent, pour la sortie duquel le potentiel de la terre est le potentiel de référence, et
dans lequel un circuit de transmission de signal (45) est présent pour la transmission du signal de commutation du premier comparateur (K1) au deuxième comparateur (K2), le circuit de transmission de signal (45) appliquant le signal de commutation du premier comparateur (K1) à un potentiel de tension continue, d'une manière telle que le signal de sortie du deuxième comparateur (K2) ne varie pas de manière alternative avec la fréquence de la tension de charge (U3).

2. Capteur selon la revendication 1,
dans lequel le générateur de charge (30) et le générateur de tension d'alimentation (30) sont formés par un seul et même générateur (30), et dans lequel la composante de tension alternative de la première tension d'alimentation (U1) est déterminée par la tension alternative de charge (U3).

3. Capteur selon la revendication 1 ou 2,
dans lequel la première tension d'alimentation (U1) est en outre formée avec une composante de tension continue (U5) qui, pour le fonctionnement de l'amplificateur (A) dans sa plage de travail, est différente du potentiel de la terre.

4. Capteur selon une des revendications 1 à 3,
dans lequel l'amplitude de la tension par rapport au potentiel de la terre, qui est appliquée à l'électrode de sonde (10) au moyen de la tension de charge (U3), est, par rapport à l'amplitude de la composante de tension alternative de la première tension d'alimentation (U1), différente d'au maximum 20 %, ou plus particulièrement égale à celle-ci.

5. Capteur selon une des revendications 1 à 4,
dans lequel la deuxième tension d'alimentation (U2) appliquée à la deuxième borne d'alimentation (A2) est égale au potentiel de la terre.

6. Capteur selon la revendication 5,
dans lequel, pour éviter une capacité parasite (CP2) entre la deuxième borne d'alimentation (A2) et l'entrée d'amplificateur (A3), l'amplificateur (A) est un amplificateur à transistor en collecteur commun est présent, plus particulièrement un circuit Darlington en collecteur commun ou un circuit Darlington complémentaire en collecteur commun.

7. Capteur selon une des revendications 1 à 6,
dans lequel le circuit redresseur (40) est un redresseur synchrone et dans lequel ledit redresseur synchrone est commandé au moyen de la tension de charge (U3).

8. Capteur selon une des revendications 1 à 7,
dans lequel les moyens électroniques (20), pour la génération d'un signal de sortie analogique ou d'un signal de commutation, sont constitués de valeurs de tension moyennes (MP1, MP2) qui sont produites par le circuit redresseur (40), et dans lequel le signal de sortie analogique ou le signal de commutation est émis à la sortie de capteur (50).

9. Procédé destiné à la détection d'un objet (5) avec un capteur selon une des revendications 1 à 8,
selon lequel une capacité de mesure (C1) est formée au moyen d'une électrode sonde (10) et de l'objet (5) à détecter,
selon lequel l'électrode sonde (10) est chargée au moyen d'une tension alternative de charge (U3),
selon lequel une tension aux bornes de la capacité de mesure (C1) est amplifiée avec un amplificateur (A),
selon lequel des signaux, qui sont produits sur une sortie de l'amplificateur (A), sont traités en vue d'au moins un signal de sortie, et
selon lequel le au moins un signal de sortie est produit,
selon lequel une tension continue est reliée à une deuxième borne d'alimentation (A2) de l'amplificateur (A) pour constituer une deuxième tension d'alimentation (U2), et
selon lequel une première tension d'alimentation (U1) avec une composante de tension alternative est reliée à une première borne d'alimentation (A1) de l'amplificateur (A), la composante de tension alternative étant générée avec un générateur de tension d'alimentation (30).

10. Procédé selon la revendication 9,
selon lequel les périodes d'oscillation de la tension alternative de charge (U3) comprennent chacune une première et une deuxième phase de charge (P1, P2), et
avec un circuit redresseur (40) pour les deux phases de charge (P1, P2), à chaque fois une valeur de tension moyenne (MP1, MP2) est produite, ou bien, avec un circuit redresseur (40), un signal de sortie, qui est dérivé des deux valeurs de tension moyenne (MP1, MP2) vers les deux phases de charge (P1, P2) ou qui est dérivé d'une valeur de tension moyenne (MP1, MP2) vers l'une des deux phases de charge (P1, P2), est produit.
